# EUROPEAN PATENT SPECIFICATION

(11) **EP 4 517 813 B1**
(45) Date of publication and mention of the grant of the patent: **29.04.2026**
(21) Application number: 24196243.0
(22) Date of filing: 23.08.2024
(51) Int. Cl.: H10W 40/22, H10W 40/40

(54) **PIN-FIN HEAT SINK**
STIFTRIPPENKÜHLKÖRPER
DISSIPATEUR THERMIQUE À AILETTES EN FORME DE BROCHE

(30) Priority: 24.08.2023 CN 202311075154
(43) Date of publication of application: 05.03.2025
(73) Proprietor: Suzhou XiZ-Tech. Co., Ltd, Suzhou, Jiangsu 215128 (CN)
(72) Inventor: SUN, Shuaijie, Suzhou, Jiangsu 215128 (CN); XU, Yitao, Suzhou, Jiangsu 215128 (CN); ZOU, Xin, Suzhou, Jiangsu 215128 (CN); WANG, Tao, Suzhou, Jiangsu 215128 (CN); LU, Kai, Suzhou, Jiangsu 215128 (CN)
(74) Representative: Argyma

(56) References cited:
- DE-A1- 102007 044 537
- JP-A- 2016 201 391
- US-A1- 2019 137 195

## Description

### TECHNICAL FIELD

The present invention relates to the field of heat sink technologies, and in particular, to a pin-fin heat sink.

### BACKGROUND

Pin-finheat sinks are widely used in various fields. Currently, most pin-fin heat sinks are in regular pin-fin shapes such as a round shape, a square shape, and an oval shape, and are easy to be processed. With increasing heat flow density of power devices, higher requirements are placed on a heat dissipation capability of the pin-fin heat sink. However, a pin-fin component (a heat dissipation pillar or a pin pillar) in an existing shape cannot meet the requirements. Therefore, to further reduce the thermal resistance of the pin-fin heat sink, it is necessary to optimize the shape of the pin-fin component. In addition, pressure drop of the cooling system also needs to be designed and considered due to the limitation of the pump power. Therefore, a pin-fin component with unique shape and arrangement method that has strong heat transfer ability and can adapt to the pressure drop condition of a cooling systemis urgently needed to guide the design of pin-fin heat sinks.

US 2019/137195 A1 and DE 10 2007 044537 A1 disclose pin-fin heat sinks having heat dissipation pillars disposed on a substrate.

### SUMMARY

To resolve the foregoing problem, the present invention provides a pin-fin heat sink, including a substrate and a plurality of heat dissipation pillars disposed on the substrate. The plurality of heat dissipation pillars are arranged on a heat dissipation surface of the substrate crosswise, a cross-sectional shape of the heat dissipation pillar is an axisymmetric convex polygon, and a symmetric axis of the axisymmetric convex polygon is parallel to an incoming flow direction.

A plurality of side surfaces of the heat dissipation pillar are successively classified, along the incoming flow direction, as an incoming flow surface facing the incoming flow direction, a pair of parallel side surfaces parallel to the incoming flow direction, and a backflow surface facing away from the incoming flow direction, and the axisymmetric convex polygon is enclosed by the incoming flow surface, the pair of parallel side surfaces, and the backflow surface.

The incoming flow surface successively includes a forward incoming flow surface and a pair of oblique incoming flow surfaces along the incoming flow direction, the forward incoming flow surface is perpendicular to the incoming flow direction, the two oblique incoming flow surfaces are symmetrical with respect to the symmetric axis, and the two oblique incoming flow surfaces are inclined away from each other along the incoming flow direction.

The pair of parallel side surfaces includes two parallel side surfaces parallel to the incoming flow direction, and the two parallel side surfaces are symmetrical with respect to the symmetric axis.

The backflow surface includes at least one pair of backflow oblique surfaces, the two backflow oblique surfaces are inclined toward each other along the incoming flow direction, and the two backflow oblique surfaces are symmetrical with respect to the symmetric axis.

Preferably, the two backflow oblique surfaces intersect with each other.

Preferably, the backflow surface further includes a backflow incoming flow surface, the backflow incoming flow surface is perpendicular to the incoming flow direction, and the two backflow oblique surfaces are connected through the backflow incoming flow surface.

Preferably, the backflow surface successively includes at least two pairs of backflow oblique surfaces along the incoming flow direction.

Preferably, gaps between two adjacent heat dissipation pillars are 0.5 mm to 2 mm.

Preferably, a width-length ratio of the heat dissipation pillar is 0.3 to 0.8, a width direction of the heat dissipation pillar is parallel to the incoming flow direction, and a length direction of the heat dissipation pillar is perpendicular to the incoming flow direction.

Preferably, a length, a width, and a height of the heat dissipation pillar are respectively 1.25 mm to 10 mm, 1 mm to 3 mm, and 4 mm to 8 mm, and the height of the heat dissipation pillar is a maximum distance between a top surface of the heat dissipation pillar and the heat dissipation surface.

Preferably, a ratio of a length of the forward incoming flow surface to a length of the heat dissipation pillar is 0.25 to 0.35, and both a length direction of the forward incoming flow surface and a length direction of the heat dissipation pillar are perpendicular to the incoming flow direction.

Preferably, a ratio of a width of the parallel side surface to a width of the heat dissipation pillar is 0.4 to 0.6, and both a width direction of the parallel side surface and a width direction of the heat dissipation pillar are parallel to the incoming flow direction.

It is also described the following : the axisymmetric convex polygon is enclosed by the forward incoming flow surface, the pair of oblique incoming flow surfaces, the pair of parallel side surfaces, and the pair of backflow oblique surfaces; the length, the width, and the height of the heat dissipation pillar are respectively 2.7 mm, 1.9 mm, and 4 mm; and the ratio of the length of the forward incoming flow surface to the length of the heat dissipation pillar is 0.3, the gap between the heat dissipation pillars is 0.9mm, and the ratio of the width of the parallel side surface to the width of the heat dissipation pillar is 0.51.

Preferably, the two oblique incoming flow surfaces and the two backflow oblique surfaces form two groups of parallel surfaces in different directions.

Preferably, gaps between nearest oblique incoming flow surface and backflow oblique surface of adjacent heat dissipation pillars are less than or equal to gaps between parallel side surfaces of adjacent heat dissipation pillars.

Preferably, an outwardly extending rounded corner is disposed at a corner between every two side surfaces of the heat dissipation pillar.

Preferably, a baffle wall structure and an arrangement region are disposed on the heat dissipation surface, the plurality of heat dissipation pillars are located in the arrangement region, and the baffle wall structure is disposed around the arrangement region to limit fluid flow in the arrangement region.

Compared with the conventional technology, the present invention has the following technical effects:
1. A heat transfer area ratio of the incoming flow surface that is of the heat dissipation pillar and that faces the incoming flow direction is large, so that more heat is dissipated by the incoming flow surface with a strong heat transfer capability, thereby reducing a thermal resistance.
2. A circulation area (the circulation area = the gap between two parallel side surfaces of adjacent heat dissipation pillars × the height of the heat dissipation pillar) perpendicular to the incoming flow direction is relatively small, a scour speed of a fluid on the incoming flow surface is larger, and an average heat transfer coefficient of the incoming flow surface is further increased through cooperation with the forward incoming flow surface perpendicular to the incoming flow direction.
3. The two oblique incoming flow surfaces and the two backflow oblique surfaces of the heat dissipation pillar form the two groups of parallel surfaces in different directions, to form arrangement similar to close-packed arrangement when the plurality of heat dissipation pillars are arranged crosswise, so that the heat dissipation pillars are arranged as much as possible in a specific region, to obtain a larger heat transfer area.
4. Because the arrangement similar to the close-packed arrangement can be formed, circulation areas between the heat dissipation pillars can always be kept close to the same, and a flow rate can always be kept to be high, so that a large convective heat transfer coefficient can be obtained on a surface of the heat dissipation pillar.
5. Proper length and width of the heat dissipation pillar can be selected with reference to thermal resistance and pressure drop requirements, to adjust the thermal resistance and a pressure drop.

Certainly, any product implementing the present invention does not necessarily need to achieve all the foregoing advantages at the same time.

### BRIEF DESCRIPTION OF DRAWINGS

In order to explain the technical solutions in the embodiments of the present invention or in the conventional technology more clearly, the drawings used in the description of the embodiments or the conventional technology will be briefly introduced below. Clearly, the drawings in the following description are merely some embodiments of the present invention. For those of ordinary skill in the art, other drawings can be obtained based on these drawings without creative efforts.
FIG. 1 is a three-dimensional diagram of a pin-fin heat sink according to an embodiment of the present invention;
FIG. 2 shows a cross-sectional shape and an arrangement manner of a heat dissipation pillar according to an embodiment of the present invention;
FIG. 3 is a schematic diagram of a structure in which a backflow surface of a heat dissipation pillar has three surfaces according to an embodiment of the present invention;
FIG. 4 is a schematic diagram of a structure in which a backflow surface of a heat dissipation pillar has four surfaces according to an embodiment of the present invention;
FIG. 5 is a schematic diagram of a structure in which a gap between nearest oblique incoming flow surface and backflow oblique surface of adjacent heat dissipation pillars may be less than or equal to a gap between parallel side surfaces of adjacent heat dissipation pillars according to an embodiment of the present invention;
FIG. 6 is a schematic diagram of a structure in which gaps between nearest oblique incoming flow surfaces and backflow oblique surfaces of adjacent heat dissipation pillars in different rows are inconsistent according to an embodiment of the present invention;
FIG. 7 is a diagram of thermal resistance comparison of heat dissipation pillars of different shapes according to an embodiment of the present invention;
FIG. 8 is a diagram of thermal resistance and pressure drop comparison of heat sinks whose heat dissipation pillars have different lengths and widths according to an embodiment of the present invention; and
FIG. 9 is a schematic diagram of a structure in which an outwardly extending rounded corner is disposed on a heat dissipation pillar according to an embodiment of the present invention.

### DESCRIPTION OF EMBODIMENTS

The technical solutions in the embodiments of the present invention will be clearly and fully described in combination with the accompanying drawings of the embodiments of the present invention. Clearly, the described embodiments are merely some rather than all of the embodiments of the present invention. Based on the embodiments of the present invention, all other embodiments obtained by those of ordinary skill in the art without creative efforts should fall within the protection scope of the present invention.

The technical solutions of the present invention will be described in detail below by specific embodiments. The following several specific embodiments may be mutually combined, and same or similar concepts or processes may not be repeatedly described in some embodiments.

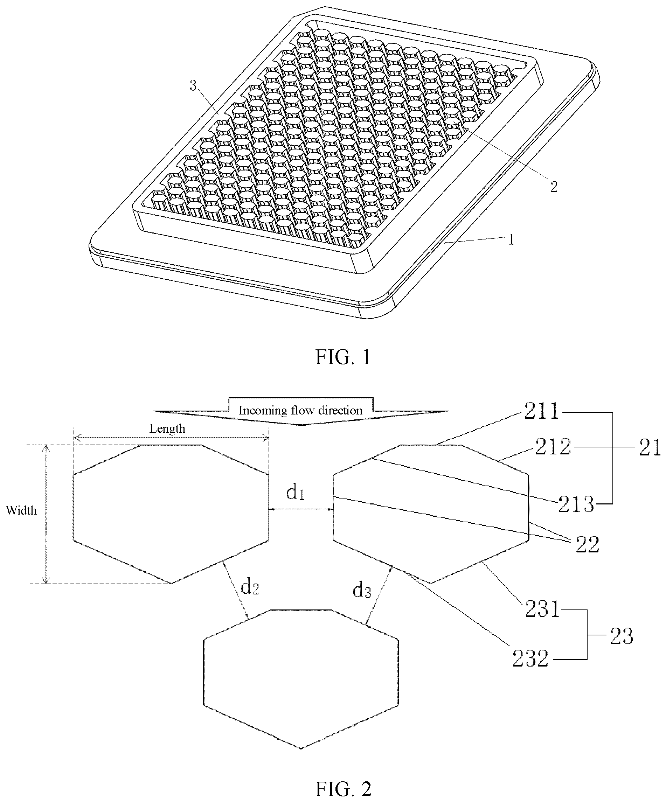

Refer to FIG. 1. A pin-fin heat sink is provided, and includes a substrate 1 and a plurality of heat dissipation pillars 2 (pin-fin components). The substrate 1 includes a heat dissipation surface and a heat absorption surface. The heat absorption surface is in contact with a heat source to be cooled. The plurality of heat dissipation pillars 2 are arranged on the heat dissipation surface crosswise.

A baffle wall structure 3 and an arrangement region are disposed on the heat dissipation surface of the substrate 1. The arrangement region may be rectangular, fan-shaped, or the like. The heat dissipation pillars 2 are located in the arrangement region. The baffle wall structure 3 is disposed around the arrangement region to limit fluid flow in the arrangement region. The substrate 1, the heat dissipation pillars 2, and the baffle wall structure 3 are processed and formed integrally. A material is copper, aluminum, stainless steel, or alloy. A processing manner may be machining, forging and pressing, or the like.

The heat dissipation pillar 2 is of a polyhedron structure. A cross-sectional shape of the heat dissipation pillar 2 is an axisymmetric convex polygon, and a symmetric axis of the axisymmetric convex polygon is parallel to an incoming flow direction. In this embodiment, the incoming flow direction is an initial direction offluid (cooling medium). After the fluid enters, a flow direction is changed based on a shape of the heat dissipation pillar 2.

Refer to FIG. 2. A plurality of side surfaces of the heat dissipation pillar 2 are successively classified, along the incoming flow direction, as an incoming flow surface 21 facing the incoming flow direction, a pair of parallel side surfaces 22 parallel to the incoming flow direction, and a backflow surface 23 facing away from the incoming flow direction. The axisymmetric convex polygon is enclosed by the incoming flow surface 21, the pair of parallel side surfaces 22, and the backflow surface 23.

In a preferred embodiment, the incoming flow surface 21 includes a forward incoming flow surface 211 and a pair of oblique incoming flow surfaces successively disposed along the incoming flow direction. The pair of oblique incoming flow surfaces (a first oblique incoming flow surface 213 and a second oblique incoming flow surface 212 shown in FIG. 2) are connected to two sides of the forward incoming flow surface 211, and the forward incoming flow surface 211 is located on a side that is of each of the two oblique incoming flow surfaces and that faces the incoming flow direction. The forward incoming flow surface 211 directly faces the incoming flow direction, that is, the forward incoming flow surface 211 is perpendicular to the incoming flow direction. During heat dissipation, a fluid with a high flow rate that flows out from a gap between two side surfaces 22 on adjacent heat dissipation pillars continuously scours the incoming flow surface 21, where the forward incoming flow surface 211 is perpendicular to the incoming flow direction, has an extremely thin boundary layer, a large convective heat transfer coefficient, and a strong heat transfer effect. Because the cross-sectional shape of the heat dissipation pillar 2 is an axisymmetric convex polygon, the two oblique incoming flow surfaces are symmetrical with respect to the symmetric axis of the axisymmetric convex polygon. In this embodiment, the two oblique incoming flow surfaces are inclined away from each other along the incoming flow direction, that is, the two oblique incoming flow surfaces are gradually away from each other along the incoming flow direction. Compared with a rectangular heat dissipation pillar, in this embodiment, a flow pressure drop of the heat sink can be reduced by adding the two oblique incoming flow surfaces. In this embodiment, compared with a case in which there is only one forward incoming flow surface 211 perpendicular to the incoming flow direction, on the premise that there is a specific gap between the heat dissipation pillars 2 (the gap between the heat dissipation pillars 2 is usually limited by a processing capability), more rows of heat dissipation pillars 2 can be arranged by adding the two oblique incoming flow surfaces, so that a quantity of heat dissipation pillars 2 is increased, and a total heat transfer area is increased.

The pair of parallel side surfaces 22 includes two parallel side surfaces 22. Both of the two parallel side surfaces 22 are parallel to the incoming flow direction, and the two parallel side surfaces 22 are symmetrical with respect to the symmetric axis of the axisymmetric convex polygon.

The backflow surface 23 includes two backflow oblique surfaces (a first backflow oblique surface 232 and a second backflow oblique surface 231 shown in FIG. 2). The two backflow oblique surfaces are inclined toward each other along the incoming flow direction (that is, the two backflow oblique surfaces gradually approach each other along the incoming flow direction), and the two backflow oblique surfaces are symmetrical with respect to the symmetric axis of the axisymmetric convex polygon. The two oblique incoming flow surfaces are respectively connected to the two backflow oblique surfaces through the two parallel side surfaces 22.

Refer to FIG. 2. In an embodiment, the axisymmetric convex polygon is enclosed by the forward incoming flow surface 211, the two oblique incoming flow surfaces, the two parallel side surfaces 22, and the two backflow oblique surfaces that are successively disposed along the incoming flow direction, that is, the two backflow oblique surfaces directly intersect with each other. In this embodiment, the pin-fin heat sink has only one incoming flow direction.

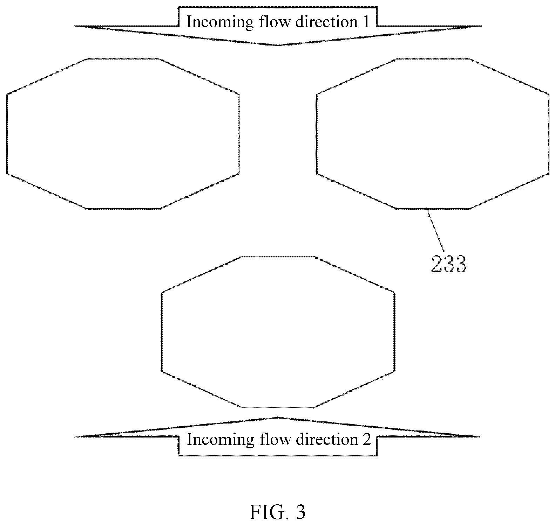

Refer to FIG. 3. In another embodiment, in addition to the two backflow oblique surfaces, the backflow surface 23 further includes a backflow incoming flow surface 233. The backflow incoming flow surface 233 is perpendicular to the incoming flow direction. The two backflow oblique surfaces are connected through the backflow incoming flow surface 233, that is, the axisymmetric convex polygon is enclosed by the forward incoming flow surface 211, the two oblique incoming flow surfaces, the two parallel side surfaces 22, the two backflow oblique surfaces, and the backflow incoming flow surface 233 that are successively disposed along the incoming flow direction. Because both the backflow incoming flow surface 233 and the forward incoming flow surface 211 are perpendicular to the incoming flow direction, the backflow incoming flow surface 233 may alternatively be used as the forward incoming flow surface 211. In this case, an incoming flow direction 2 is opposite to the original incoming flow direction 1, that is, the pin-fin heat sink has two opposite incoming flow directions (refer to the incoming flow direction 1 and the incoming flow direction 2 shown in FIG. 3) for selection and use.

In this embodiment, the two oblique incoming flow surfaces and the two backflow oblique surfaces form two groups of parallel surfaces in different directions. For ease of description, the two oblique incoming flow surfaces are respectively named as a first oblique incoming flow surface 213 and a second oblique incoming flow surface 212, and the two backflow oblique surfaces are respectively named as a first backflow oblique surface 232 and a second backflow oblique surface 231. The first oblique incoming flow surface 213 and the second oblique incoming flow surface 212 are respectively connected to the first backflow oblique surface 232 and the second backflow oblique surface 231 through the two parallel side surfaces 22. The first oblique incoming flow surface 213 is parallel to the second backflow oblique surface 231, that is, the first oblique incoming flow surface 213 and the second backflow oblique surface 231 form a first group of parallel surfaces. The second oblique incoming flow surface 212 is parallel to the first backflow oblique surface 232, that is, the second oblique incoming flow surface 212 and the first backflow oblique surface 232 form a second group of parallel surfaces. The two oblique incoming flow surfaces and the two backflow oblique surfaces form the two groups of parallel surfaces in different directions, to form arrangement similar to close-packed arrangement when the plurality of heat dissipation pillars 2 are arranged crosswise, so that the heat dissipation pillars 2 can be arranged as much as possible in a specific region, to obtain a larger heat transfer area. Because the arrangement similar to the close-packed arrangement can be formed, circulation areas between the heat dissipation pillars 2 can always be kept close to the same, and flow rate of the fluid can always be kept to be high, so that a large convective heat transfer coefficient can be obtained on a surface of the heat dissipation pillar 2. The close-packed arrangement means that flow channel spacings between the heat dissipation pillars 2 are always kept the same. As shown in FIG. 2, a heat dissipation pillar I, a heat dissipation pillar II, and a heat dissipation pillar III are adjacent to each other, a gap d₁ between a parallel side surface 22 of the heat dissipation pillar I and a parallel side surface 22 of the heat dissipation pillar II, a gap d₂ between a second backflow oblique surface 231 of the heat dissipation pillar I and a first oblique incoming flow surface 213 of the heat dissipation pillar III, and a gap d₃ between a second oblique incoming flow surface 212 of the heat dissipation pillar III and a first backflow oblique surface 232 of the heat dissipation pillar II are kept the same. For example, the close-packed arrangement is similar to orthohexagnal or rectangular crossed arrangement.

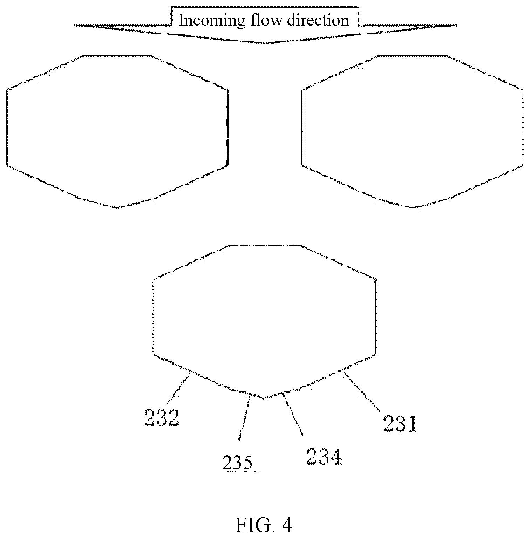

In a third embodiment, the backflow surface includes at least two pairs of backflow oblique surfaces along the incoming flow direction. As shown in FIG. 4, the backflow surface includes two pairs of backflow oblique surfaces successively disposed along the incoming flow direction. In addition to a first pair of backflow oblique surfaces (for example, the first backflow oblique surface 232 and the second backflow oblique surface 231 shown in FIG. 2), the backflow surface further includes a second pair of backflow oblique surfaces. For ease of description, the second pair of backflow oblique surfaces includes a third backflow oblique surface 235 and a fourth backflow oblique surface 234. The third backflow oblique surface 235 and the fourth backflow oblique surface 234 are respectively connected to the first backflow oblique surface 232 and the second backflow oblique surface 231. The third backflow oblique surface 235 and the fourth backflow oblique surface 234 are inclined toward each other along the incoming flow direction respectively relative to the first backflow oblique surface 232 and the second backflow oblique surface 231, and the third backflow oblique surface 235 and the fourth backflow oblique surface 234 are symmetrical with respect to the symmetric axis of the axisymmetric convex polygon. In this embodiment, the axisymmetric convex polygon is enclosed by the forward incoming flow surface 211, the two oblique incoming flow surfaces, the two parallel side surfaces 22, the first pair of backflow oblique surfaces, and the second pair of backflow oblique surfaces that are successively disposed along the incoming flow direction.

The heat dissipation pillar 2 further includes a top surface. The top surface intersects with the side surfaces of the heat dissipation pillar 2, but is not necessarily parallel to the heat dissipation surface. The top surface may be flexibly designed as a surface parallel to or not parallel to the heat dissipation surface with reference to a structure of a heat dissipation water channel.

A length direction of the heat dissipation pillar 2 is perpendicular to the incoming flow direction, and a length of the heat dissipation pillar 2 is a maximum spacing perpendicular to the incoming flow direction, that is, the length of the heat dissipation pillar 2 is a spacing between two parallel side surfaces 22, and the length of the heat dissipation pillar 2 is preferably 1.25 mm to 10 mm. A width direction of the heat dissipation pillar 2 is parallel to the incoming flow direction, and a width of the heat dissipation pillar 2 is a maximum spacing parallel to the incoming flow direction, that is, the width of the heat dissipation pillar 2 is a maximum spacing between the forward incoming flow surface 211 and the backflow surface 23, and the width of the heat dissipation pillar 2 is preferably 1 mm to 3 mm. A height of the heat dissipation pillar 2 refers to a maximum spacing between the top surface and the heat dissipation surface of the substrate 1, and the height of the heat dissipation pillar 2 is preferably 4 mm to 8 mm.

The forward incoming flow surface 211 has a largest heat transfer coefficient on the incoming flow surface 21. A length of the forward incoming flow surface 211 affects an average heat transfer coefficient of the incoming flow surface 21 and the shape of the heat dissipation pillar 2, and further affects the arrangement of the heat dissipation pillars 2 and the total heat transfer area, thermal resistance, and pressure drop of the pin-fin heat sink. An optimal heat transfer capability effect can be achieved through adjustment based on simulation results or experimental results. A ratio of the length of the forward incoming flow surface 211 to the length of the heat dissipation pillar 2 is preferably 0.25-0.35. Both a length direction of the forward incoming flow surface 211 and a length direction of the heat dissipation pillar 2 are perpendicular to the incoming flow direction, the length of the forward incoming flow surface 211 is a length perpendicular to the incoming flow direction, and a length of the heat dissipation pillar 2 is a distance between two parallel side surfaces 22.

Changes in a width of the parallel side surface 22 also affect the shape of the heat dissipation pillar 2, and further affects the arrangement of the heat dissipation pillars 2 and the total heat transfer area, the thermal resistance, and the pressure drop of the pin-fin heat sink. Therefore, in this embodiment, a ratio of the width of the parallel side surface 22 to the width of the heat dissipation pillar 2 is preferably 0.4 to 0.6, where both a width direction of the heat dissipation pillar 2 and a width direction of the parallel side surface 22 are parallel to the incoming flow direction, and the width of the parallel side surface 22 is a size parallel to the incoming flow direction.

The heat dissipation pillars 2 are arranged crosswise, and the arrangement similar to the close-packed arrangement can be formed when the heat dissipation pillars 2 are arranged crosswise, so that the heat dissipation pillars 2 are arranged as much as possible in a specific region, to obtain a larger heat transfer area and a larger convective heat transfer coefficient on a surface of the heat dissipation pillar 2. In this embodiment, gaps between adjacent heat dissipation pillars 2 are preferably 0.5 mm to 2 mm.

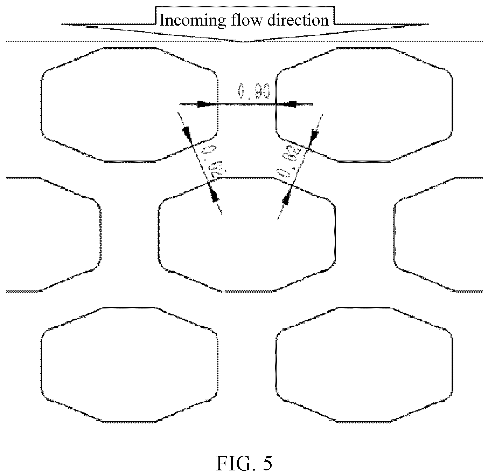

Further, gaps between nearest oblique incoming flow surface and backflow oblique surface of adjacent heat dissipation pillars 2 may be less than or equal to gaps between parallel side surfaces 22 of adjacent heat dissipation pillars 2. As shown in FIG. 5, a gap d₁ between a parallel side surface 22 of a heat dissipation pillar I and a parallel side surface 22 of a heat dissipation pillar II is 0.9, a gap d₂ between a second backflow oblique surface 231 of the heat dissipation pillar I and a first oblique incoming flow surface 213 of a heat dissipation pillar III is 0.62, and a gap d₃ between a second oblique incoming flow surface 212 of the heat dissipation pillar III and a first backflow oblique surface 232 of the heat dissipation pillar II is 0.62.

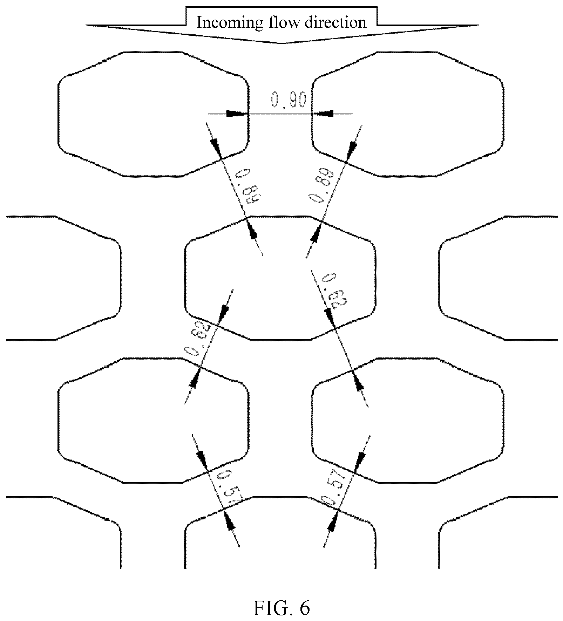

Further, gaps between nearest oblique incoming flow surfaces and backflow oblique surfaces of adjacent heat dissipation pillars in different rows may be inconsistent. As shown in FIG. 6, a gap between nearest oblique incoming flow surface and backflow oblique surface in a second row and a first row is 0.89, a gap between nearest oblique incoming flow surface and backflow oblique surface in a third row and the second row is 0.62, a gap between nearest oblique incoming flow surface and backflow oblique surface in a fourth row and the third row is 0.57, ..., and so on. Therefore, arrangement density of the heat dissipation pillars can be changed along a flow direction. A location with denser heat dissipation pillars 2 has a stronger heat dissipation capability. An arrangement rule of the heat dissipation pillars 2 may be sparse first and then dense, sparse first and then dense and then sparse, or dense first and then sparse along the flow direction. Similarly, the arrangement density of the heat dissipation pillars 2 is adjusted based on heat distribution and temperature uniformity requirement of a component to be cooled.

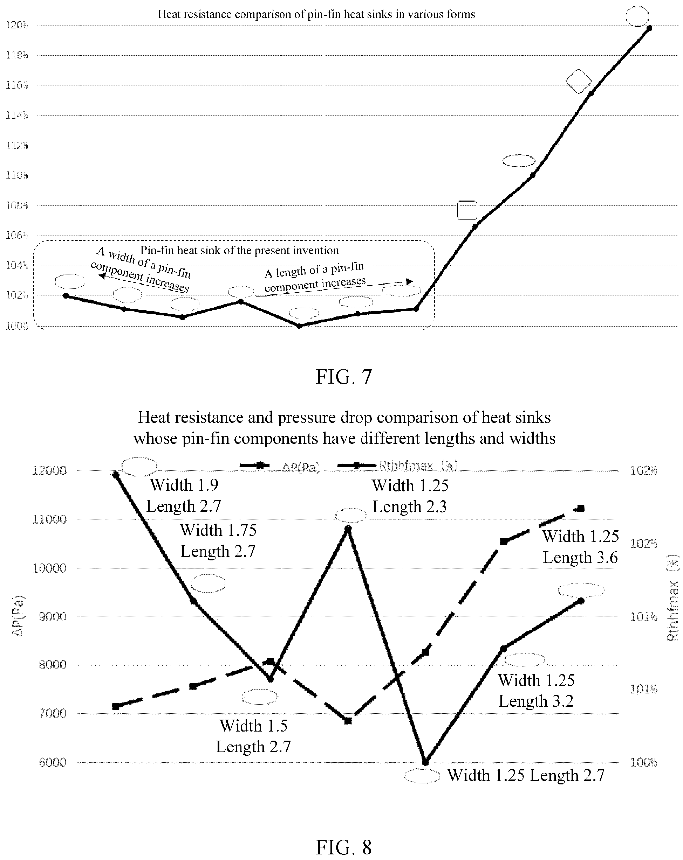

On the surface of the heat dissipation pillar 2, a heat transfer coefficient of the incoming flow surface 21 is usually the largest. Compared with a conventional heat dissipation pillar in a square shape, a round shape, a diamond shape, or another shape, a width-length ratio of the heat dissipation pillar 2 in this embodiment is smaller, and an area ratio of the incoming flow surface 21 (an area of the incoming flow surface 21 is a sum of areas of the forward incoming flow surface 211 and the two oblique incoming flow surfaces, and the area ratio of the incoming flow surface 21 = the area of the incoming flow surface 21/a sum of the area of the incoming flow surface 21, areas of the two parallel side surfaces 22, and an area of the backflow surface 23) is larger. The pin-fin heat sink in this embodiment can dissipate more heat by using the incoming flow surface 21 with a strong heat transfer capability, thereby reducing a convective heat transfer temperature difference, and further reducing the thermal resistance of the pin-fin heat sink. In addition, because the width-length ratio of the heat dissipation pillar 2 in this embodiment is smaller, in a same arrangement region, a circulation area (the circulation area = the gap between two parallel side surfaces 22 of adjacent heat dissipation pillars 2 × the height of the heat dissipation pillar 2) perpendicular to the incoming flow direction is relatively small, a scour speed of the fluid on the incoming flow surface 21 is larger, and the average heat transfer coefficient of the incoming flow surface 21 is further increased through cooperation with the forward incoming flow surface 211 perpendicular to the incoming flow direction. Compared with an oval heat dissipation pillar 2 having same cross-sectional length and width, although the oval heat dissipation pillar 2 also has a small width-length ratio and a large heat transfer area of an incoming flow surface 21, because the heat dissipation pillars 2 in this embodiment can form the close-packed arrangement, a larger total heat transfer area and a larger convective heat transfer coefficient on the surface of the heat dissipation pillar 2 can be achieved. Therefore, the pin-fin heat sink provided in this embodiment still has a smaller thermal resistance. FIG. 7 shows thermal resistance comparison between the pin-fin heat sink provided in this embodiment and square, round, diamond, and oval pin-fin heat sinks. It can be learned that the thermal resistance of the pin-fin heat sink provided in this embodiment is 6% less than a conventional square pin-fin heat sink, and is 19% less than a round pin-fin heat sink.

Sizes such as the length and the width of the heat dissipation pillar 2 affect the shape of the heat dissipation pillar 2, and further affect the arrangement of the heat dissipation pillars 2 on the heat dissipation surface and the heat transfer coefficient on the surface of the heat dissipation pillar 2, thus finally affecting the thermal resistance and the pressure drop of the pin-fin heat sink. FIG. 8 shows simulated analysis performed within a range in which the length and the width of the heat dissipation pillar 2 are respectively 2.3 mm to 3.6 mm and 1.25 mm to 1.9 mm. A result shows that on the premise that the heat dissipation pillars 2 are in a specific arrangement region, as the length of the heat dissipation pillar 2 increases, the pressure drop of the heat sink is gradually increased and the thermal resistance is first reduced and then increased. As the width of the heat dissipation pillar 2 increases, because a quantity of arranged heat dissipation pillars 2 is reduced, the pressure drop of the heat sink is gradually reduced, but the thermal resistance is increased. In actual application, proper sizes, such as the length, the width, the height, a length of a side surface, and a length of a plane perpendicular to the incoming flow direction, of the heat dissipation pillar 2 may be determined according to a simulation method or an experimental method with reference to a heat dissipation capability requirement and a pressure drop requirement of a flow channel system.

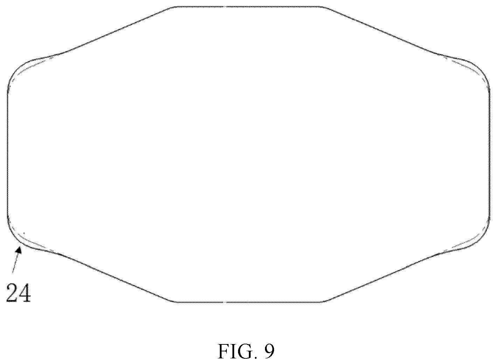

For positions such as an edge and a corner of the heat dissipation pillar 2, necessary chamfer, rounded corner, or the like may be added based on an actual processing capability. Further, as shown in FIG. 9, on the premise that the processing capability allows, a rounded corner 24 located at a corner between every twoside surfaces of the heat dissipation pillar 2 may extend appropriately to the outside of the heat dissipation pillar 2, to further slightly increase the heat transfer area.

## Claims

1. A pin-fin heat sink, comprising a substrate (1) and a plurality of heat dissipation pillars (2) disposed on the substrate (1), wherein the plurality of heat dissipation pillars (2) are arranged on a heat dissipation surface of the substrate (1) crosswise, a cross-sectional shape of the heat dissipation pillar (2) is an axisymmetric convex polygon, and a symmetric axis of the axisymmetric convex polygon is parallel to an incoming flow direction;
a plurality of side surfaces (22) of the heat dissipation pillar (2) are successively classified, along the incoming flow direction, as an incoming flow surface (21) facing the incoming flow direction, a pair of parallel side surfaces (22) parallel to the incoming flow direction, and a backflow surface (23) facing away from the incoming flow direction, and the axisymmetric convex polygon is enclosed by the incoming flow surface (21), the pair of parallel side surfaces (22), and the backflow surface (23);
the incoming flow surface (21) successively comprises a forward incoming flow surface (211) and a pair of oblique incoming flow surfaces (21) along the incoming flow direction, the forward incoming flow surface (211) is perpendicular to the incoming flow direction, the two oblique incoming flow surfaces (21) are symmetrical with respect to the symmetric axis, and the two oblique incoming flow surfaces (21) are inclined away from each other along the incoming flow direction;
the pair of parallel side surfaces (22) comprises two parallel side surfaces (22) parallel to the incoming flow direction, and the two parallel side surfaces (22) are symmetrical with respect to the symmetric axis; and
the backflow surface (23) comprises at least one pair of backflow oblique surfaces, the two backflow oblique surfaces are inclined toward each other along the incoming flow direction, and the two backflow oblique surfaces are symmetrical with respect to the symmetric axis.

2. The pin-fin heat sink according to claim 1, wherein the two backflow oblique surfaces intersect with each other.

3. The pin-fin heat sink according to claim 1, wherein the backflow surface (23) further comprises a backflow incoming flow surface (233), the backflow incoming flow surface (233) is perpendicular to the incoming flow direction, and the two backflow oblique surfaces are connected through the backflow incoming flow surface (233).

4. The pin-fin heat sink according to claim 1, wherein the backflow surface (23) successively comprises at least two pairs of backflow oblique surfaces along the incoming flow direction.

5. The pin-fin heat sink according to claim 1, wherein gaps between two adjacent heat dissipation pillars (2) are 0.5 mm to 2 mm.

6. The pin-fin heat sink according to claim 1, wherein a width-length ratio of the heat dissipation pillar (2) is 0.3 to 0.8, a width direction of the heat dissipation pillar (2) is parallel to the incoming flow direction, and a length direction of the heat dissipation pillar (2) is perpendicular to the incoming flow direction.

7. The pin-fin heat sink according to claim 6, wherein a length, a width, and a height of the heat dissipation pillar (2) are respectively 1.25 mm to 10 mm, 1 mm to 3 mm, and 4 mm to 8 mm, and the height of the heat dissipation pillar (2) is a maximum distance between a top surface of the heat dissipation pillar (2) and the heat dissipation surface.

8. The pin-fin heat sink according to claim 1, wherein a ratio of a length of the forward incoming flow surface (211) to a length of the heat dissipation pillar (2) is 0.25 to 0.35, and both a length direction of the forward incoming flow surface (211) and a length direction of the heat dissipation pillar (2) are perpendicular to the incoming flow direction.

9. The pin-fin heat sink according to claim 1, wherein a ratio of a width of the parallel side surface (22) to a width of the heat dissipation pillar (2) is 0.4 to 0.6, and both a width direction of the parallel side surface (22) and a width direction of the heat dissipation pillar (2) are parallel to the incoming flow direction.

10. The pin-fin heat sink according to claim 1, wherein the two oblique incoming flow surfaces (21) and the two backflow oblique surfaces form two groups of parallel surfaces in different directions.

11. The pin-fin heat sink according to claim 1, wherein gaps between nearest oblique incoming flow surface (21) and backflow oblique surface of adjacent heat dissipation pillars (2) are less than or equal to gaps between parallel side surfaces (22) of adjacent heat dissipation pillars (2).

12. The pin-fin heat sink according to claim 1, wherein an outwardly extending rounded corner (24) is disposed at a corner between every two side surfaces (22) of the heat dissipation pillar (2).

13. The pin-fin heat sink according to claim 1, wherein a baffle wall structure (3) and an arrangement region are disposed on the heat dissipation surface, the plurality of heat dissipation pillars (2) are located in the arrangement region, and the baffle wall structure (3) is disposed around the arrangement region to limit fluid flow in the arrangement region.

## Patentansprüche

1. Stiftrippenkühlkörper, der ein Substrat (1) und mehrere Wärmeableitsäulen (2), die auf dem Substrat (1) angeordnet sind, umfasst, wobei die mehreren Wärmeableitsäulen (2) kreuzweise auf einer Wärmeableitfläche des Substrats (1) angeordnet sind, eine Querschnittsform der Wärmeableitsäule (2) ein achsensymmetrisches konvexes Polygon ist und eine symmetrische Achse des achsensymmetrischen konvexen Polygons parallel zu einer Einströmrichtung verläuft;
mehrere Seitenflächen (22) der Wärmeableitsäule (2) entlang der Einströmrichtung nacheinander als eine Einströmfläche (21), die der Einströmrichtung zugewandt sind, ein Paar von parallelen Seitenflächen (22), die parallel zur Einströmrichtung verlaufen, und eine Rückströmfläche (23), die der Einströmrichtung abgewandt ist, klassifiziert sind und das achsensymmetrische konvexe Polygon von der Einströmfläche (21), dem Paar von parallelen Seitenflächen (22) und der Rückströmfläche (23) umschlossen ist;
die Einströmfläche (21) nacheinander eine vordere Einströmfläche (211) und ein Paar von schrägen Einströmflächen (21) entlang der Einströmrichtung umfasst, die vordere Einströmfläche (211) senkrecht zur Einströmrichtung verläuft, die zwei schrägen Einströmflächen (21) zur symmetrischen Achse symmetrisch sind und die zwei schrägen Einströmflächen (21) entlang der Einströmrichtung voneinander weg geneigt sind;
das Paar von parallelen Seitenflächen (22) zwei parallele Seitenflächen (22) parallel zur Einströmrichtung umfasst und die zwei parallelen Seitenflächen (22) zur symmetrischen Achse symmetrisch sind; und
die Rückströmfläche (23) wenigstens ein Paar von schrägen Rückströmflächen umfasst, die zwei schrägen Rückströmflächen entlang der Einströmrichtung zueinander geneigt sind und die zwei schrägen Rückströmflächen zur symmetrischen Achse symmetrisch sind.

2. Stiftrippenkühlkörper nach Anspruch 1, wobei die zwei schrägen Rückströmflächen einander schneiden.

3. Stiftrippenkühlkörper nach Anspruch 1, wobei die Rückströmfläche (23) ferner eine Rückström-Einströmfläche (233) umfasst, die Rückström-Einströmfläche (233) senkrecht zur Einströmrichtung verläuft, und die zwei schrägen Rückströmflächen durch die Rückström-Einströmfläche (233) verbunden sind.

4. Stiftrippenkühlkörper nach Anspruch 1, wobei die Rückströmfläche (23) nacheinander wenigstens zwei Paare von schrägen Rückströmflächen entlang der Einströmrichtung umfasst.

5. Stiftrippenkühlkörper nach Anspruch 1, wobei Zwischenräume zwischen zwei benachbarten Säulen (2) 0,5 mm bis 2 mm betragen.

6. Stiftrippenkühlkörper nach Anspruch 1, wobei ein Breiten-Längen-Verhältnis der Wärmeableitsäule (2) 0,3 bis 0,8 beträgt, eine Breitenrichtung der Wärmeableitsäule (2) parallel zur Einströmrichtung verläuft und eine Längenrichtung der Wärmeableitsäule (2) senkrecht zur Einströmrichtung verläuft.

7. Stiftrippenkühlkörper nach Anspruch 6, wobei eine Länge, eine Breite und eine Höhe der Wärmeableitsäule (2) 1,25 mm bis 10 mm, 1 mm bis 3 mm beziehungsweise 4 mm bis 8 mm betragen und die Höhe der Wärmeableitsäule (2) ein maximaler Abstand zwischen einer oberen Fläche der Wärmeableitsäule (2) und der Wärmeableitfläche ist.

8. Stiftrippenkühlkörper nach Anspruch 1, wobei ein Verhältnis einer Länge der vorderen Einströmfläche (211) zu einer Länge der Wärmeableitsäule (2) 0,25 bis 0,35 beträgt und sowohl eine Längenrichtung der vorderen Einströmfläche (211) als auch eine Längenrichtung der Wärmeableitsäule (2) senkrecht zur Einströmrichtung verlaufen.

9. Stiftrippenkühlkörper nach Anspruch 1, wobei ein Verhältnis einer Breite der parallelen Seitenfläche (22) zu einer Breite der Wärmeableitsäule (2) 0,4 bis 0,6 beträgt und sowohl eine Breitenrichtung der parallelen Seitenfläche (22) als auch eine Breitenrichtung der Wärmeableitsäule (2) parallel zur Einströmrichtung verlaufen.

10. Stiftrippenkühlkörper nach Anspruch 1, wobei die zwei schrägen Einströmflächen (21) und die zwei schrägen Rückströmflächen zwei Gruppen von parallelen Flächen in verschiedenen Richtungen bilden.

11. Stiftrippenkühlkörper nach Anspruch 1, wobei Zwischenräume zwischen nächstgelegenen schrägen Einströmfläche (21) und schrägen Rückströmfläche benachbarter Wärmeableitsäulen (2) kleiner als oder gleich Zwischenräumen zwischen parallelen Seitenflächen (22) benachbarter Wärmeableitsäulen (2) sind.

12. Stiftrippenkühlkörper nach Anspruch 1, wobei eine sich nach außen erstreckende abgerundete Ecke (24) an einer Ecke zwischen jeden zwei Seitenflächen (22) der Wärmeableitsäule (2) angeordnet ist.

13. Stiftrippenkühlkörper nach Anspruch 1, wobei eine Sperrwandstruktur (3) und ein Anordnungsbereich auf der Wärmeableitfläche angeordnet sind, die mehreren Wärmeableitsäulen (2) sich im Anordnungsbereich befinden und die Sperrwandstruktur (3) um den Anordnungsbereich herum angeordnet ist, um Fluidströmung im Anordnungsbereich zu begrenzen.

## Revendications

1. Un dissipateur thermique à broche-ailette, comprenant un substrat (1) et une pluralité de piliers de dissipation thermique (2) disposés sur le substrat (1), dans lequel la pluralité de piliers de dissipation thermique (2) sont agencés en traverse sur une surface de dissipation thermique du substrat (1), une forme de section transversale du pilier de dissipation thermique (2) est un polygone convexe axisymétrique et un axe symétrique du polygone convexe axisymétrique est parallèle à une direction de flux entrant ;
une pluralité de surfaces latérales (22) du pilier de dissipation thermique (2) sont classées successivement, le long de la direction de flux entrant, en tant que surface de flux entrant (21) orientée vers la direction de flux entrant, paire de surfaces latérales parallèles (22) parallèles à la direction de flux entrant et surface de flux inverse (23) orientée à distance de la direction de flux entrant, et le polygone convexe axisymétrique est entouré par la surface de flux entrant (21), la paire de surfaces latérales parallèles (22) et la surface de flux inverse (23) ;
la surface de flux entrant (21) comprend successivement une surface de flux entrant avant (211) et une paire de surfaces de flux entrant obliques (21) le long de la direction de flux entrant, la surface de flux entrant avant (211) est perpendiculaire à la direction de flux entrant, les deux surfaces de flux entrant obliques (21) sont symétriques par rapport à l'axe symétrique et les deux surfaces de flux entrant obliques (21) sont inclinées à distance l'une de l'autre le long de la direction de flux entrant ;
la paire de surfaces latérales parallèles (22) comprend deux surfaces latérales parallèles (22) parallèles à la direction de flux entrant, et les deux surfaces latérales parallèles (22) sont symétriques par rapport à l'axe symétrique ; et
la surface de flux inverse (23) comprend au moins une paire de surfaces obliques de flux inverse, les deux surfaces obliques de flux inverse sont inclinées l'une vers l'autre le long de la direction de flux entrant, et les deux surfaces obliques de flux inverse sont symétriques par rapport à l'axe symétrique.

2. Le dissipateur thermique à broche-ailette selon la revendication 1, dans lequel les deux surfaces obliques de flux inverse se croisent entre elles.

3. Le dissipateur thermique à broche-ailette selon la revendication 1, dans lequel la surface de flux inverse (23) comprend en outre une surface de flux entrant de flux inverse (233), la surface de flux entrant de flux inverse (233) est perpendiculaire à la direction de flux entrant, et les deux surfaces obliques de flux inverse sont reliées à travers la surface de flux entrant de flux inverse (233).

4. Le dissipateur thermique à broche-ailette selon la revendication 1, dans lequel la surface de flux inverse (23) comprend successivement au moins deux paires de surfaces obliques de flux inverse le long de la direction de flux entrant.

5. Le dissipateur thermique à broche-ailette selon la revendication 1, dans lequel des intervalles entre deux piliers de dissipation thermique (2) adjacents sont de 0,5 mm à 2 mm.

6. Le dissipateur thermique à broche-ailette selon la revendication 1, dans lequel un rapport largeur-longueur du pilier de dissipation thermique (2) est 0,3 à 0,8, une direction de largeur du pilier de dissipation thermique (2) est parallèle à la direction de flux entrant et une direction de largeur du pilier de dissipation thermique (2) est perpendiculaire à la direction de flux entrant.

7. Le dissipateur thermique à broche-ailette selon la revendication 6, dans lequel une longueur, une largeur et une hauteur du pilier de dissipation thermique (2) sont respectivement de 1,25 mm à 10 mm, de 1 mm à 3 mm et de 4 mm à 8 mm, et la hauteur du pilier de dissipation thermique (2) est une distance maximum entre une surface supérieure du pilier de dissipation thermique (2) et la surface de dissipation thermique.

8. Le dissipateur thermique à broche-ailette selon la revendication 1, dans lequel un rapport d'une longueur de la surface de flux entrant avant (211) sur une longueur du pilier de dissipation thermique (2) est 0,25 à 0,35, et une direction de longueur de la surface de flux entrant avant (211) et une direction de longueur du pilier de dissipation thermique (2) sont toutes deux perpendiculaires à la direction de flux entrant.

9. Le dissipateur thermique à broche-ailette selon la revendication 1, dans lequel un rapport d'une largeur de la surface latérale parallèle (22) sur une largeur du pilier de dissipation thermique (2) est 0,4 à 0,6, et une direction de largeur de la surface latérale parallèle (22) et une direction de largeur du pilier de dissipation thermique (2) sont toutes deux parallèles à la direction de flux entrant.

10. Le dissipateur thermique à broche-ailette selon la revendication 1, dans lequel les deux surfaces de flux entrant obliques (21) et les deux surfaces obliques de flux inverse forment deux groupes de surfaces parallèles dans différentes directions.

11. Le dissipateur thermique à broche-ailette selon la revendication 1, dans lequel des intervalles entre la surface de flux entrant oblique (21) la plus proche et la surface oblique de flux inverse des piliers de dissipation thermique (2) adjacents sont inférieurs ou égaux à des intervalles entre des surfaces latérales parallèles (22) de piliers de dissipation thermique (2) adjacents.

12. Le dissipateur thermique à broche-ailette selon la revendication 1, dans lequel un coin arrondi s'étendant vers l'extérieur (24) est disposé au niveau d'un coin entre chacune des deux surfaces latérales (22) du pilier de dissipation thermique (2).

13. Le dissipateur thermique à broche-ailette selon la revendication 1, dans lequel une structure de paroi déflectrice (3) et une région d'agencement sont disposées sur la surface de dissipation thermique, la pluralité des piliers de dissipation thermique (2) sont situés dans la région d'agencement et la structure de paroi déflectrice (3) est disposée autour de la région d'agencement pour limiter le flux de fluide dans la région d'agencement.
